(19) Europäisches Patentamt
European Patent Office
Office européen des brevets

(11) **EP 3 427 907 A1**

(12) **EUROPEAN PATENT APPLICATION**
published in accordance with Art. 153(4) EPC

(43) Date of publication:
**16.01.2019 Bulletin 2019/03**

(51) Int Cl.:
***B25J 15/06*** *(2006.01)*        ***B65G 49/07*** *(2006.01)*
***H01L 21/677*** *(2006.01)*

(21) Application number: **16893417.2**

(22) Date of filing: **08.03.2016**

(86) International application number:
**PCT/JP2016/057065**

(87) International publication number:
**WO 2017/154085 (14.09.2017 Gazette 2017/37)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(71) Applicant: **Nano-Tem Co., Ltd.**
**Nagaoka-shi, Niigata 940-0021 (JP)**

(72) Inventors:
• **TAKATA, Atsushi**
**Nagaoka-shi**
**Niigata 940-0045 (JP)**

• **TAKATSU, Masakazu**
**Mitsuke-shi**
**Niigata 954-0058 (JP)**
• **OHASHI, Kyosuke**
**Nagaoka-shi**
**Niigata 940-0824 (JP)**
• **ISHIZAKI, Kozo**
**Nagaoka-shi**
**Niigata 940-0053 (JP)**
• **ONODERA, Norio**
**Nagaoka-shi**
**Niigata 940-0021 (JP)**

(74) Representative: **Prüfer & Partner mbB**
**Patentanwälte · Rechtsanwälte**
**Sohnckestraße 12**
**81479 München (DE)**

(54) **CONVEYANCE PAD, AND CONVEYANCE DEVICE AND CONVEYANCE METHOD USING SAME**

(57)     This invention is to provide a conveying pad, a conveying apparatus and a conveying method using the conveying pad, capable of exactly attracting and fixing an object placed on a part of a conveying surface or levitating the object, by virtue of an attracting force or levitating force of the conveying pad. The conveying pad 2 is made of a porous substrate communicated with a large number of pores, and by depressurizing or pressurizing the back surface of the conveying pad 2, an object W placed on the front surface of the conveying pad 2 is attracted or levitated, thus satisfying a relational equation between an area ratio $\alpha$ of the object covering the surface of the conveying pad 2 and a conductance ratio $\beta$.

[Fig.1]

**Description**

Technical Field

The present invention relates to a conveying pad which attracts and thus fixes an object such as a wafer and a polymer film, or conveys the object by levitating the same in a non-contact manner. This invention also relates to a conveying apparatus and a conveying method using the conveying pad. In detail, this invention relates to a conveying apparatus and a conveying method (using the conveying pad) which, by depressurizing the back surface of the conveying pad using a vacuum pump or pressurizing the back surface using a compressor, can attract and thus fix the object placed on the surface of a porous substrate through a plurality of pores formed thereon, or convey the object by levitating the same in a non-contact manner, even if a part of conveying surface is not covered by the object. Further, the present invention relates to a method of preventing a static electricity (a peeling electrification) generated when an object being conveyed by attraction is separated from an attraction pad and the compressor is operated to levitate the object.

Background Art

Regarding a vacuum chuck which uses a vacuum pump to depressurize the back surface of a conveying pad with respect to the front surface thereof on which an object such as a wafer and a polymer film is attracted and thus fixed, and which attracts and thus holds the object to be conveyed through the pores communicated with the front surface and the back surface, it is necessary to keep the inner pressure on the back surface at a pressure close to vacuum, with respect to the atmospheric pressure on the front surface. With such a vacuum chuck, if an object being conveyed fails to cover the whole surface serving as a conveying surface, a part of the pores will be open to the conveying surface. As a result, an outside air will flow inwardly through the pores, and it is thus impossible to obtain a sufficient differential pressure between the front surface and the back surface, resulting in a failure to obtain a predetermined attracting force.

As a conventional vacuum chuck, there is known a vacuum chuck in which a large number of pores communicated with the front surface and the back surface have a small diameter, and the conductance of all pores has thus been reduced (for example, refer to Patent Document 1 and Patent Document 2).

According to such a conventional vacuum chuck, even if some of the pores are open to the front surface without being covered by an object being conveyed, flow rate of air flowing from the front surface to the back surface through the pores is restricted and the differential pressure between the front surface and the back surface can be kept constant and even an object placed on a part of the conveying surface can be positioned and held on the surface with a predetermined attracting force.

Citation List

Patent Documents

Patent Document 1: Japanese Utility Model Publication No. 43-16175
Patent Document 2: Japanese Patent No. 2693720

Summary of Invention

Technical Problems

However, in the above-discussed conventional vacuum chuck, while an attention is focused on lowering the conductance of the vacuum chuck by reducing the size of many pores and thus keeping the internal pressure constant, it is impossible to obtain a predetermined attracting force for attracting an object only by lowering the conductance. Namely, an object will be attracted towards the front surface of the porous substrate in a vertical direction perpendicular to its bottom surface covering the openings of the pores, using a differential pressure between the atmospheric pressure acting under the object (in a direction from the front surface to the back surface) and an internal pressure acting upwardly (in a direction from the back surface to the front surface). Accordingly, such an attracting force can be calculated by multiplying the total area of the openings of the pores covered with object by the differential pressure.

Therefore, simply reducing the size of the pores or decreasing the pore density in order to reduce the conductance of the whole vacuum chuck, will reduce the total area of the openings of the pores covered by object being conveyed, hence rendering it impossible to obtain an attracting force required by the vacuum chuck.

As described above, the vacuum chuck attracts an object to be conveyed using a pressure difference between the external pressure and the internal pressure. On the other hand, the inventors of the present invention have realized that an object to be conveyed can be levitated by reversing the external pressure and the internal pressure. However, none of the conventional conveying pads can be used for either the attracting or levitating.

Furthermore, it is necessary to prevent a static electricity generated when fixing and releasing an object with a vacuum chuck.

The present invention has been accomplished in view of the above problem existing in prior art, and it is an object of the present invention to provide a conveying pad, a conveying apparatus and a conveying method using the conveying pad, capable of exactly attracting and fixing or levitating an object placed on part of conveying surface, and thus conveying the object in a noncontact manner. Another object of the present invention is to eliminate a trouble caused due to an electrostatic electrification when attracting and conveying the object.

Solution to the Problems

In order to achieve the above object, the conveying pad of the present invention is a pad for attracting and fixing or levitating an object to convey the object in a non-contact manner, wherein
the conveying pad includes a porous substrate communicated with a plurality of pores,
vacuuming or pressurizing is performed on the back surface of the porous substrate to attract or levitate the object placed on the front surface of the porous substrate,
a relationship between an area ratio $\alpha$ of the object covering the surface of the porous substrate and a conductance ratio $\beta$ satisfies the following equation (a):

$$(1 - \alpha) \times \beta < [(|P1 - P3| / PW) - 1] \cdot\cdot\cdot\cdot\cdot\cdot (a)$$

wherein

$$\alpha = S1/S0$$

$$\beta = k \times d^2 \times \eta/t$$

k: constant
d: pore diameter
$\eta$: porosity
t: thickness of porous substrate
S1: area of object being conveyed (which means a projected area of the object on the porous substrate)
S0: area of porous substrate (which means a projected area of the porous substrate)
PW: pressure-converted value of weight of an object being conveyed
P1: external pressure
P3: vacuum pump pressure or compressor pressure

In the present invention, if a relationship between the area ratio $\alpha$ of the object covering the surface of the porous substrate which is a conveying pad and the conductance ratio $\beta$ satisfies an equation (a), it is possible to exactly attract and fix the object placed on a part of the conveying surface or levitate the object to convey it in a non-contact manner, by virtue of an attracting force or levitating force of the conveying pad.

In equation (a), $(1 - \alpha)$ represents an opening degree of the surface of the conveying pad. In fact, the smaller the $(1 - \alpha)$, the larger the attracting force or the levitating force.

Further, in equation (a), $\beta$ represents a conductance which is an index indicating an ease of air flow through a conveying pad having pores. When the conveying pad is made of an ordinary ceramic, the general fact will be the smaller the $\beta$, the larger the attracting force or the levitating force. However, when $\beta$ is zero, neither attraction nor levitation is possible, so there is an optimum value in this vicinity.

If PW represents a pressure-converted value of the weight of an object being conveyed, when the product of $(1 - \alpha)$ and $\beta$ is smaller than $[(|P1 - P3| / PW) - 1]$, it is possible to exactly attract and fix an object placed on a part of the conveying surface or levitate and thus convey the object in a non-contact manner, by virtue of the attracting force or levitating force of the conveying pad.

Moreover, in the above configuration of the present invention, it is preferable that the shape of the conveying pad is flat, cylindrical, or U-shaped.

If the shape of the conveying pad is flat, an object to be conveyed is preferably an object such as a wafer having a certain thickness. On the other hand, if an object to be conveyed is cylindrical or U-shaped, an object to be conveyed is preferably in the form of a roll such as a polymer film.

Further, in the configuration of the present invention, it is preferable that the porosity $\eta$ is 20 - 60%, the pore diameter d is 0.5 - 10 $\mu$m, and the thickness t of the porous substrate is 2 - 20 mm.

The conveying pad of the present invention can be made into a porous substrate having a porosity $\eta$ of 20 - 60% by virtue of ceramic sintering. When the porosity is less than 20%, part of the pores will be blocked, and the front and back surfaces will become partially un-communicated with each other. As a result, it is impossible to ensure a stable attracting force or levitating force. On the other hand, if the porosity exceeds 60%, voids will be increased and the strength will be deteriorated, and there will be a fear of breakage.

Further, the conductance ratio $\beta$ is proportional to the square of the pore diameter d. Accordingly, by setting the pore diameter d at a small diameter of 0.5 - 10 $\mu$m, it is possible to efficiently set the conductance ratio $\beta$ of the conveying pad at an optimum value.

Furthermore, the conductance ratio $\beta$ is inversely proportional to the thickness t of the porous substrate. Therefore, by setting the thickness t of the porous substrate at 2 - 20 mm, it is possible to reduce the conductance ratio $\beta$ of the conveying pad.

Moreover, in the configuration of the present invention, the conveying pad is not absolutely necessary to be sealed on its side surface.

A conventional conveying pad was absolutely necessary to be sealed on its side surface. In the present invention, if the conveying pad is made to satisfy equation (a), since the conductance ratio $\beta$ of the conveying pad is small and the air flow resistance is large, it is possible to exactly attract and fix an object placed on a part of the conveying surface, or levitate the object so as to convey it in a non-contact manner, even if the side surface of the conveying pad is not sealed. Consequently, it becomes possible to reduce a production cost and omit some processes.

Further, in the configuration of the present invention, the porous substrate contains metal or ceramics, and has a volume resistivity of $10^{10}$ $\Omega \cdot$ m or less.

When a conveying pad whose porous substrate contains metal or ceramics and whose volume resistivity is $10^{10}$ $\Omega \cdot$ m or less is used to attract an object to convey it, and when the object is to be separated from the conveying pad, it is possible to separate the object while continuously levitating the same .

Moreover, when an object is to be separated from the conveying pad, it is possible to prevent an electrostatic electrification by using the above-described conveying pad.

Effects of the Invention]

According to the present invention, it is possible to exactly attract and fix an object placed on a part of a conveying surface or levitate the object to convey it in a non-contact manner, by virtue of the attracting force or the levitating force of the conveying pad.

In addition, when conveying an object using an attracting force or when separating the object from the conveying pad, it is possible to prevent an electrostatic electrification so as to safely separate the object while continuously levitating the same.

Brief Description of Drawings

Fig. 1 is a schematic view showing a conveying pad according to the first embodiment of the present invention.
Fig. 2 is a perspective view showing a conveying pad according to the second embodiment of the present invention.
Fig. 3 is a graph showing a relationship between the conductance ratio $\beta$ and the differential pressure $\Delta$P (a pressure difference between the front surface and back surface of a conveying pad) in the present invention.
Fig. 4 is a graph showing a relationship between an area ratio $\alpha$ and a conductance ratio $\beta$ of an object being conveyed in the present invention.
Fig. 5 is another graph showing a relationship between an area ratio $\alpha$ and a conductance ratio $\beta$ of an object being conveyed in the present invention.
Fig. 6 is a graph showing a relationship between an area ratio $\alpha$ of an object being conveyed and a differential pressure $\Delta$P (a pressure difference between the front surface and back surface of a conveying pad) in the present invention.

Description of Embodiments

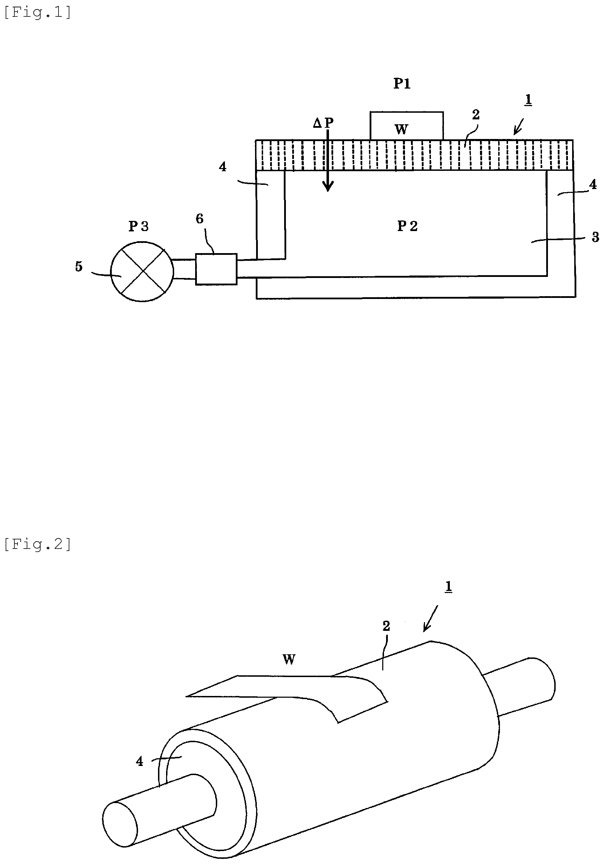

In the following, description will be given to a conveying pad formed according to the first embodiment of the present invention, with reference to Fig. 1. As shown in Fig. 1, a conveying apparatus 1 includes : a conveying pad 2 which attracts an object W and thus hold the object on the pad's surface; a conveying apparatus main body 4 having a depressurizing chamber or a pressurizing chamber 3 on the back side of the conveying pad 2; and a flow meter 6 for detecting a flow rate per unit time of a vacuum pump or a compressor 5 which exhausts air from the depressurizing chamber 3 or supplies air to the pressurizing chamber 3.

As shown in Fig. 1, when an object W to be conveyed is placed on the conveying pad 2 whose internal pressure is P2, a differential pressure $\Delta P$ between the atmospheric pressure P1 and the internal pressure P2 will be applied in the vertical direction to the openings of the pores covered by the object W, so that the object will be attracted or levitated. In this way, the object W will receive an attracting force or levitating force F which can be calculated by multiplying the sum total of the opening areas of all the pores covered with the object W by the differential pressure $\Delta P$.

The conveying pad 2 is formed of, for example, a square porous ceramic substrate with each side being 60 cm. In this embodiment, air pores having a diameter of 0.5 - 10 $\mu$m are mutually closely formed, forming a conveying pad 2 having a porosity $\eta$ of 20 - 60%. Here, the porosity $\eta$ means that the pores communicated with the back surface are formed in a uniform density on the conveying pad 2, representing a ratio of total opening area of air pores in unit area per unit area of the surface of the conveying pad 2. By using the ceramic sintering technique, it is possible to form a porous ceramic substrate having a pore diameter of 0.5 - 10 $\mu$m and a porosity $\eta$ of 20 - 60%.

If P2 represents a pressure within the depressurizing or pressurizing chamber 3 (hereinafter, referred to as an internal pressure) when the vacuum pump or the compressor 5 having a vacuum pump pressure or a compressor pressure P3 is used for depressurizing or pressurizing from the depressurizing chamber or the pressurizing chamber 3 of the conveying apparatus 1, a flow rate Q can be expressed by the following equation (b).

$$Q = C1 \times (P1 - P2) = C2 \times (P2 - P3) \quad \cdots \cdots \cdots (b)$$

here:

Q: flow rate
C1: conductance between P1 and P2
C2: conductance between P2 and P3
P1: external pressure
P2: internal pressure
P3: vacuum pump pressure or compressor pressure

When equation (b) is transformed, the following equation (c) can be obtained.

$$\Delta P = (P1 - P2) = (P1 - P3) / (1 + C1/C2) \quad \cdots \cdots \cdots (c)$$

Since C1 in the above equation (c) corresponds to a conductance $\gamma \times (1 - \alpha)$ of a portion excluding the area ratio $\alpha$ of an object covering the surface of the porous substrate, and if this is substituted therefor, the following equation (d) can be obtained. Here, $\gamma/C2 = \beta$ (conductance ratio).

$$\Delta P = (P1 - P2) = (P1 - P3) / [1 + \beta \times (1 - \alpha)] \quad \cdots \cdots \cdots (d)$$

here:

$$\beta = k \times d^2 \times \eta / t$$

k: constant
d: pore diameter
$\eta$: porosity

t: thickness of porous substrate

Here, when the difference between the external pressure P1 and the internal pressure P2 is ∆P, the following equation (e) can be obtained.

$$\Delta P = (P1 - P3) / [1 + \beta (1 - \alpha)] \quad \cdots \cdots (e)$$

Here, it is required that even if the object is upside down, it can be attracted without falling down, or can be levitated if the object is not upside down.

Therefore, it is necessary for the differential pressure ∆P to be larger than a pressure-converted value PW of the weight of the object being conveyed.
here:

$$PW = (W/S1)$$

PW: pressure-converted value of the weight of an object being conveyed
W: weight of an object being conveyed
S1: area of an object being conveyed

Therefore, the following equation (f) can be obtained.

$$\Delta P = (P1 - P3) / [1 + \beta (1 - \alpha)] > PW \quad \cdots (f)$$

(when attracted)

$$\Delta P = (P3 - P1) / [1 + \beta (1 - \alpha)] > PW \quad \cdots (g)$$

(when levitated)

The following equations (h), (i) can be obtained by transforming the above equations (f), (g).

$$\beta \times (1 - \alpha) < [(P1 - P3)/PW) -1] \quad \cdots \cdots (h)$$

$$\beta \times (1 - \alpha) < [(P3 - P1)/PW) - 1] \quad \cdots \cdots (i)$$

In this way, it is possible to obtain the following equation (a) which is the condition of the present invention.

$$\beta \times (1 - \alpha) < [(|P1 - P3|/PW) -1] \quad \cdots \cdots (a)$$

If a conveying pad 2 is selected which has the area ratio $\alpha$ of an object covering the surface of the porous substrate and which has the conductance ratio $\beta$, both satisfying the equation (a), even if the side surface of the conveying pad 2 is not sealed, it is still possible to exactly ensure a conveying apparatus 1 having an attracting force or levitating force equal to or larger than the gravity of an object, regardless of the size of an object being conveyed.

Fig. 2 is a view showing a conveying pad formed according to the second embodiment of the present invention.

In this embodiment, an object W to be conveyed is a polymer film, and the shape of the conveying pad 2 is cylindrical.

As shown in Fig. 2, by forming the conveying pad 2 into a cylindrical shape, it is possible for a thin film to be wrapped around the conveying pad 2, so that the thin film can be attracted, fixed and rotated accordingly, thereby rendering it possible to levitate and release the thin film at any arbitrary angle.

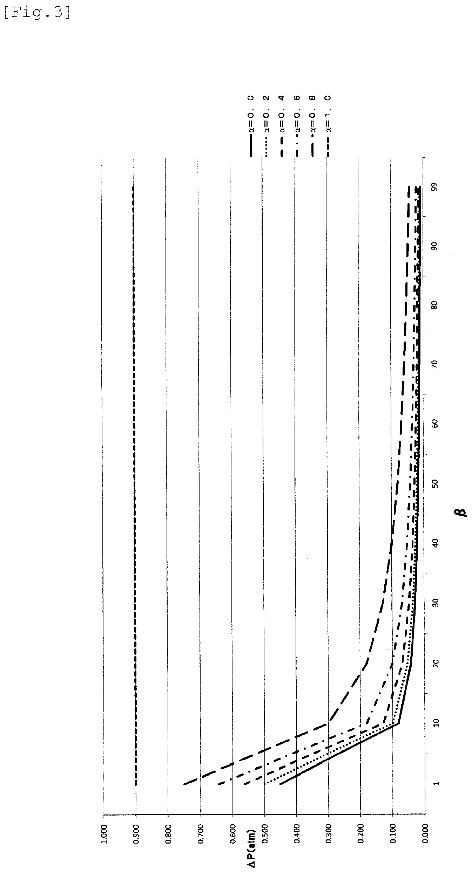

Fig. 3 is a graph showing a relationship between a conductance ratio $\beta$ and a differential pressure ∆P (a pressure

difference between the front surface and the back surface of the porous substrate) in the present invention.

As shown in Fig. 3, the differential pressure $\Delta P$ increases when there is an increase in the area ratio $\alpha$ of an object covering the surface of the porous substrate and when there is a decrease in the conductance ratio $\beta$.

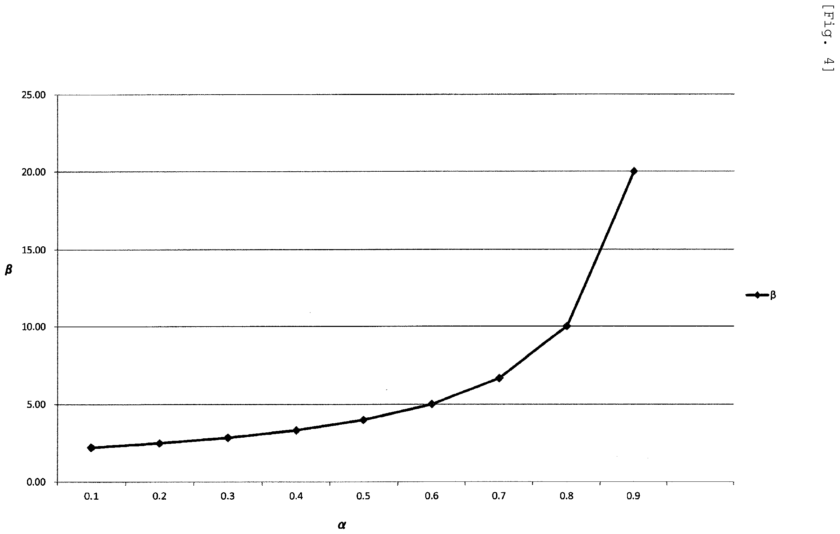

Fig. 4 is a graph showing a relationship between the area ratio $\alpha$ and the conductance ratio $\beta$ of an object when $\Delta P$ in the present invention is 0.3 atm.

As shown in Fig. 4, the conductance ratio $\beta$ increases as the area ratio $\alpha$ of the object covering the surface of the porous substrate increases.

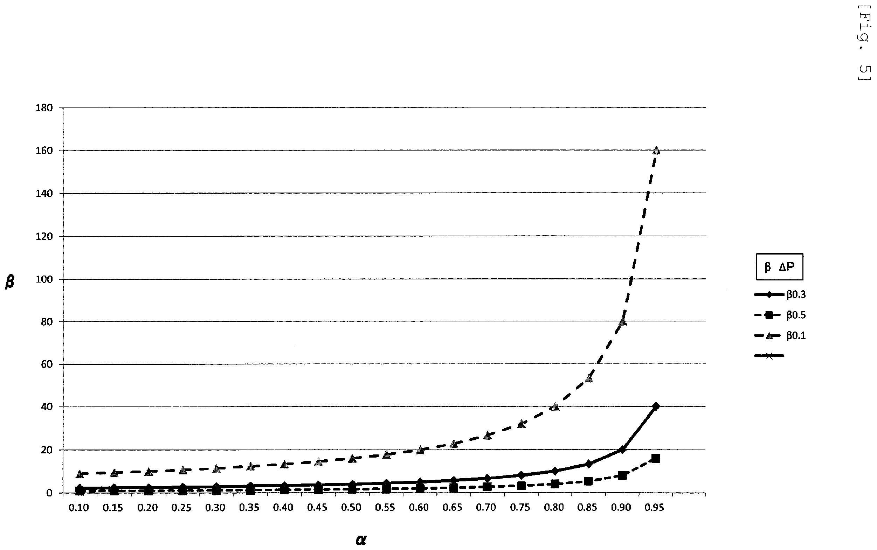

Fig. 5 is a graph showing a relationship between the area ratio $\alpha$ and the conductance ratio $\beta$ of an object when $\Delta P$ in the present invention is 0.1 - 0.5 atm.

As shown in Fig. 5, when the area ratio $\alpha$ of an object covering the surface of the porous substrate increases and $\Delta P$ decreases, the conductance ratio $\beta$ increases.

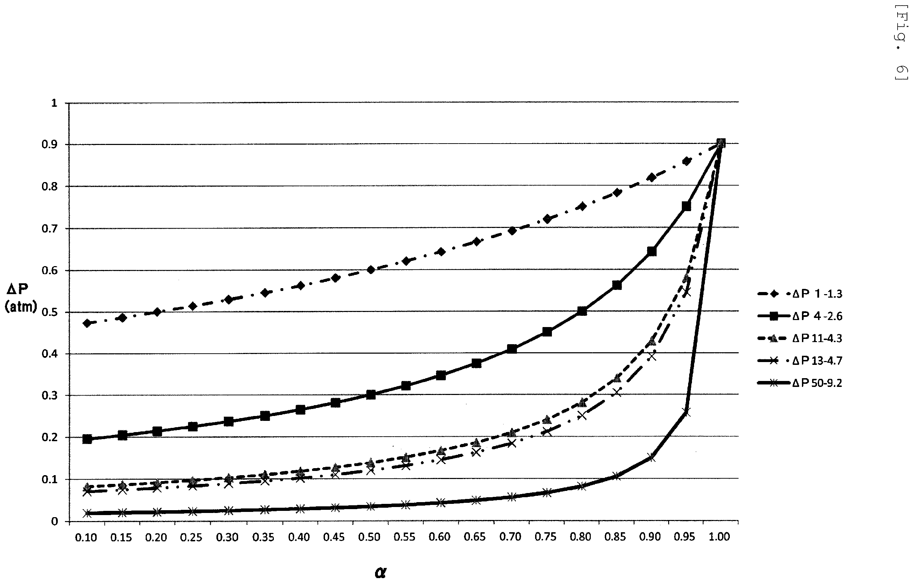

Fig. 6 is a graph showing a relationship between the area ratio $\alpha$ of an object and the differential pressure $\Delta P$ (a pressure difference between the front surface and the back surface of the conveying pad) when the conductance ratio $\beta$ in the present invention is 1 - 50.

As shown in Fig. 6, the differential pressure $\Delta P$ increases when there is an increase in the area ratio $\alpha$ of an object covering the surface of the porous substrate, and when there is a decrease in the conductance ratio $\beta$.

Examples

Table 1 shows the results of the experiments carried out on the conveying pad 2 of the present invention shown in Fig. 1 under the following conditions.

In the judgment column of Table 1, O represents an acceptable attraction or levitation, while X represents an unacceptable attraction or levitation.

<Experiment Conditions>

Pad shape: flat and cylindrical
Area ratio $\alpha$: 0.0 - 0.656 (-)
Conductance ratio $\beta$: 0.83 - 16680 (-)
Constant k: 0.1491 - 44.48
Pore diameter d: 0.5 - 50 ($\mu$m)
Porosity $\eta$: 25 - 60 (-)
Thickness t of porous substrate: 2 - 10 (mm)
Area of object S1: S0 $\times$ $\alpha$ (mm$^2$)
Area of porous substrate S0: 400 (20 mm $\times$ 20 mm) (mm$^2$) Pressure-converted value PW of the weight of an object: 0.1 (atm)
Material of porous substrate: alumina · silica type ceramics Volume resistivity of the porous substrate: $10^3$ - $10^7$ ($\Omega \cdot$ m)

[Table 1]

| NO. | $\alpha$ (-) | d ($\mu$m) | $\eta$ (-) | t (mm) | $\beta$ (-) | $(1-\alpha) \times \beta$ (-) | PW (atm) | \|P1-P3\| | (\|P1-P3\|/PW)-1 (-) | Judgement | k value (reference) |
|---|---|---|---|---|---|---|---|---|---|---|---|
| 1 | 0.656 | 0.5 | 25 | 2 | 1.39 | 0.478 | 0.1 | 0.987 | 8.87 | ○ | 44.48 |
| 2 | 0.656 | 0.5 | 25 | 2 | 1.39 | 0.478 | 0.1 | 0.592 | 4.92 | ○ | 44.48 |
| 3 | 0.656 | 50 | 30 | 2 | 16680 | 5738 | 0.1 | 0.9 | 8 | × | 44.48 |
| 4 | 0.45 | 0.5 | 25 | 2 | 1.39 | 0.7645 | 0.1 | 0.987 | 8.87 | ○ | 44.48 |
| 5 | 0.45 | 0.5 | 25 | 2 | 1.39 | 0.7645 | 01 | 0.592 | 4.92 | ○ | 44.48 |
| 6 | 0.45 | 30 | 25 | 2 | 5004 | 2752 | 0.1 | 0.9 | 8 | × | 44.48 |
| 7 | 0.09 | 0.5 | 25 | 2 | 1.39 | 1.264 | 0.1 | 0.987 | 8.87 | ○ | 44.48 |
| 8 | 0.09 | 0.5 | 25 | 2 | 1.39 | 1.264 | 0.1 | 0.592 | 4.92 | ○ | 44.48 |
| 9 | 0.09 | 20 | 25 | 2 | 2224 | 2024 | 0.1 | 0.592 | 8 | × | 44.48 |
| 10 | 0.837 | 10 | 30 | 2 | 2.237 | 0.364 | 0.1 | 0.296 | 1.96 | ○ | 0.1491 |
| 11 | 0.837 | 30 | 30 | 2 | 20.12 | 6.92 | 0.1 | 0.296 | 1.96 | × | 0.1491 |
| 12 | 0.09 | 10 | 30 | 2 | 2.236 | 2.035 | 0.1 | 0.592 | 4.92 | ○ | 0.1491 |
| 13 | 0.09 | 30 | 30 | 2 | 20.120 | 18.3 | 0.1 | 0.592 | 4.92 | × | 0.1491 |
| 14 | 0.05 | 3.7 | 46 | 2 | 2.179 | 2.07 | 0.1 | 0.839 | 7.39 | ○ | 0.692 |
| 15 | 0.5 | 5.2 | 46 | 2 | 4.358 | 2.1789 | 0.1 | 0.839 | 7.39 | ○ | 0.692 |
| 16 | 0.5 | 10 | 46 | 2 | 15.920 | 7.958 | 0.1 | 0.839 | 7.39 | × | 0.692 |
| 17 | 0.5 | 2 | 60 | 2 | 0.830 | 0.4152 | 0.1 | 0.839 | 7.39 | ○ | 0.692 |
| 18 | 0.5 | 20 | 60 | 2 | 83.040 | 41.52 | 01 | 0.839 | 7.39 | × | 0.692 |
| 19 | 0.5 | 10 | 60 | 10 | 4.152 | 2.076 | 0.1 | 0.839 | 7.39 | ○ | 0.692 |
| 20 | 0.5 | 2 | 42 | 5 | 4.000 | 2 | 0.1 | 0.9 | 8 | ○ | 11.9 |
| 21 | 0.5 | 5 | 20 | 5 | 11.9 | 5.92 | 0.1 | 0.9 | 8 | ○ | 11.9 |
| 22 | 0.01 | 20 | 40 | 5 | 1423 | 14.23 | 0.1 | 0.9 | 8 | × | 44.48 |
| 23 | 0.01 | 2 | 40 | 5 | 14.23 | 0.1423 | 0.1 | 0.9 | 8 | ○ | 44.48 |

(Note) The above No.22 and No. 23 are studies on whether or not it is possible to convey an object as a flat plate of 10 cm × 10 cm, while being levitated on a conveying path using a conveying pad of 20 cm × 500 cm.

If a conveying pad 2 is selected which has the area ratio $\alpha$ of an object covering the surface of the porous substrate and which has the conductance ratio $\beta$, both satisfying the equation (a), it is still possible to exactly ensure a conveying apparatus 1 having an attracting force or levitating force equal to or larger than the gravity of an object, regardless of the size of an object being conveyed.

In addition, when pulling an object away from the conveying pad, it was possible to separate the object by levitating it, thus rendering it possible to prevent an electrostatic electrification.

In this way, the effect of the present invention was thus confirmed.

Industrial Applicability

The present invention is suitable for holding workpieces of various sizes without changing a conveying pad, in manufacturing apparatuses for producing semiconductors, liquid crystal devices, and printed wiring boards, as well as in work processes of printing presses.

Further, in the step of removing a conveyed object, it is possible to prevent an electrostatic electrification, thus ensuring a safe removal of the conveyed object.

Explanations of Reference Numerals

2 conveying pad
W weight of an object being conveyed
PW pressure-converted value of the weight of an object being conveyed
$\alpha$ area ratio
$\beta$ conductance ratio
P1 external pressure
P2 internal pressure
P3 vacuum pump pressure or compressor pressure

**Claims**

1.   A conveying pad for attracting and fixing or levitating an object to convey the object in a non-contact manner, wherein

the conveying pad includes a porous substrate communicated with a plurality of pores,
vacuuming or pressurizing is performed on the back surface of the porous substrate to attract or levitate the object placed on the front surface of the porous substrate,
a relationship between an area ratio $\alpha$ of the object covering the surface of the porous substrate and a conductance ratio $\beta$ satisfies the following equation (a):

$$(1 - \alpha) \times \beta < [(|P1 - P3| / PW) -1] \quad \cdots \cdots \cdot (a)$$

wherein

$$\alpha = S1/S0$$

$$\beta = k \times d^2 \times \eta/t$$

k: constant
d: pore diameter
$\eta$: porosity
t: thickness of porous substrate
S1: area of object being conveyed
S0: area of porous substrate

P1: external pressure
P3: vacuum pump pressure or compressor pressure
PW: pressure-converted value of weight of an object being conveyed

2. The conveying pad according to claim 1, wherein the porous substrate is flat, cylindrical or U-shaped.

3. The conveying pad according to claim 1 or 2, wherein the porosity $\eta$ is 20 - 60%, the pore diameter d is 0.5 - 10 $\mu$m, and the thickness t of the porous substrate is 2 - 20 mm.

4. The conveying pad according to any one of claims 1 - 3, wherein the conveying pad is not sealed on its side surface.

5. The conveying pad according to any one of claims 1 - 4, wherein the porous substrate contains metal or ceramics, and has a volume resistivity of $10^{10}$ $\Omega \cdot$ m or less

6. A conveying apparatus including a conveying pad according to any one of claims 1 - 5.

7. A conveying method of attracting and conveying an object using a conveying pad according to claim 5, wherein when an object is to be separated from a conveying pad, the object is continuously levitated so as to be separated therefrom.

8. A conveying method of using a conveying pad according to claim 5, wherein when the object is to be separated from the conveyingpad, an electrostatic electrification is prevented.

[Fig.1]

[Fig.2]

[Fig.3]

[Fig. 4]

[Fig. 5]

[Fig. 6]

## INTERNATIONAL SEARCH REPORT

| | International application No. |
|---|---|
| | PCT/JP2016/057065 |

A. CLASSIFICATION OF SUBJECT MATTER
*B25J15/06(2006.01)i, B65G49/07(2006.01)i, H01L21/677(2006.01)i*

According to International Patent Classification (IPC) or to both national classification and IPC

B. FIELDS SEARCHED

Minimum documentation searched (classification system followed by classification symbols)
B25J15/06, B65G49/07, H01L21/677

Documentation searched other than minimum documentation to the extent that such documents are included in the fields searched
| Jitsuyo Shinan Koho | 1922–1996 | Jitsuyo Shinan Toroku Koho | 1996–2016 |
| Kokai Jitsuyo Shinan Koho | 1971–2016 | Toroku Jitsuyo Shinan Koho | 1994–2016 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2011-114253 A (Nano TEM Co., Ltd.), 09 June 2011 (09.06.2011), paragraphs [0002] to [0007], [0019] to [0033]; fig. 1 to 2 & WO 2011/065021 A1 & CN 102668059 A & KR 10-2012-0116909 A | 1-8 |
| Y | JP 2014-200888 A (Rohm Co., Ltd.), 27 October 2014 (27.10.2014), paragraphs [0051], [0056]; fig. 1 to 6 & US 2014/0302755 A1 paragraphs [0061], [0066]; fig. 1 to 6 | 1-8 |
| Y | JP 2001-353788 A (Asahi Kasei Corp.), 25 December 2001 (25.12.2001), paragraphs [0019], [0021] to [0023], [0026] (Family: none) | 3 |

| ☒ | Further documents are listed in the continuation of Box C. | ☐ | See patent family annex. |
|---|---|---|---|

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 29 March 2016 (29.03.16) | 12 April 2016 (12.04.16) |

| Name and mailing address of the ISA/ | Authorized officer |
|---|---|
| Japan Patent Office 3-4-3,Kasumigaseki,Chiyoda-ku, Tokyo 100-8915,Japan | |
| | Telephone No. |

Form PCT/ISA/210 (second sheet) (January 2015)

## INTERNATIONAL SEARCH REPORT

| | International application No. |
|---|---|
| | PCT/JP2016/057065 |

C (Continuation).   DOCUMENTS CONSIDERED TO BE RELEVANT

| Category* | Citation of document, with indication, where appropriate, of the relevant passages | Relevant to claim No. |
|---|---|---|
| Y | JP 2010-99826 A  (Nitto Denko Corp.),<br>06 May 2010 (06.05.2010),<br>paragraphs [0002] to [0005], [0011] to [0029];<br>fig. 1<br>& US 2011/0183108 A1<br>paragraphs [0002] to [0005], [0012] to [0030];<br>fig. 1<br>& WO 2010/035786 A1      & KR 10-2011-0067132 A<br>& CN 102164719 A          & TW 201012597 A | 4,6 |
| Y | JP 2011-14783 A  (Disco Inc.),<br>20 January 2011 (20.01.2011),<br>paragraphs [0013], [0016] to [0020], [0026];<br>fig. 2, 4<br>(Family: none) | 5,7-8 |
| Y | Microfilm of the specification and drawings<br>annexed to the request of Japanese Utility<br>Model Application No. 125397/1986(Laid-open<br>No. 32849/1988)<br>(Ishizuka Glass Co., Ltd., Shin'ei Kiko<br>Kabushiki Kaisha),<br>03 March 1988 (03.03.1988),<br>page 3, line 1 to page 4, line 13; fig. 1<br>(Family: none) | 7 |
| A | JP 2693720 B2  (CKD Corp.),<br>05 September 1997 (05.09.1997),<br>paragraphs [0004], [0008] to [0018]; fig. 1 to<br>3<br>(Family: none) | 1 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 4316175 B

- JP 2693720 B